# EUROPEAN PATENT APPLICATION

(11) **EP 0 878 992 A2**
(43) Date of publication of application: **18.11.1998**
(21) Application number: 98302540.4
(22) Date of filing: 01.04.1998
(51) Int. Cl.: H05K 13/04, H05K 13/08

(54) **Surface-mounted electronic parts positioning apparatus**

(30) Priority: 13.05.1997 JP 137643/97
(71) Applicant: Matsumoto, Kiyoshi, Tokyo (JP)
(72) Inventor: Matsumoto, Kiyoshi, Tokyo (JP)
(74) Representative: Jackson, Peter Arthur

(57) **Abstract**

A vertically movable and rotatable vacuum suction pickup tube 4 holding an electronic part with its back side directed downward, a first and a second light sources 12 and 13 selectively illuminating the top or bottom surface of the electronic part, a flat reflecting mirror 20 adapted to reciprocate below the axis of the vacuum suction pickup tube 4, and a camera 15 disposed in a plane containing said flat reflecting mirror 20 and vacuum suction pickup tube 4 and in a position where the image of the vacuum suction pickup tube 4 enters are mounted on a frame 9 moved by a drive unit. This apparatus permits directly positioning an electronic part picked up in a desired position on a printed circuit board, irrespective of the structure of the lead wires or terminals on the electronic part.

## Description

### Background of the Invention

### Field of the Invention

This invention relates to surface-mounted electronic parts positioning apparatus for mounting semiconductor devices and electronic parts constituting electronic circuits to desired positions on printed circuit boards.

### Description of the Prior Art

Japanese Provisional Patent Publication No.5-48299 of 1984 discloses a process for soldering electronic parts to printed circuit boards according to conductive circuit patterns. In this process, a vacuum nozzle sucks and grasps an electronic part. Then, the relative position of the electronic part thus grasped with respect to the nozzle is mechanically adjusted as determined previously. A conveying device carries the electronic part to a soldering point on a printed circuit board and accomplishes its positioning.

U.S. Patents 5060288 and 4235407 disclose processes that judge if correct positioning can be achieved or not by electronically photographing the condition of a printed circuit board just before an electronic part is roughly positioned according to a circuit pattern and then enlarging the photographed image of the board on a display.

However, these conventional processes necessitate that dedicated electronic parts whose wires and terminals are positioned to meet their mating components on the printed circuit boards or that their lead wires and terminals can be seen from above while they are being held in position by the suction nozzle. Thus, they cannot be used for electronic parts whose connection terminals are small solder balls or pins provided on the under side of printed circuit boards or packages.

To solve these problems, some other types of positioning apparatus have been proposed, too. One of them, for example, has a camera fixed in place with its lens directed upward to photograph the solder balls or pins on the under side of the electronic part held in position by vacuum-suction pickup tube. By processing their image signals thus obtained, their relative position with respect to the vacuum-suction pickup tube is determined. Then, each electronic part is positioned on the printed circuit board after correcting its position or taking into consideration its relative positional error with respect to the vacuum-suction pickup tube.

This apparatus, however, requires an additional step to move the pickup tube together with the electronic part picked up thereby to a position where the camera is disposed for obtaining image signals for subsequent positioning. The need to travel over a longer distance than in the processes in which the sucked electronic parts are carried directly to the desired positions on the printed circuit board decreases the number of parts mounted per unit time.

By comparison, an apparatus according to this invention comprises a vertically movable and rotatable electronic part holder that grasps an electronic part with its back side directed downward, a light source selectively illuminating the top or bottom side of the electronic part, a flat reflecting mirror capable of reciprocating downwardly along the axis of said electronic part holder, and a camera disposed in a plane containing said flat reflecting mirror and electronic part holder and in a position where the image of the electronic part holder enters, which are all mounted on a frame moved by a drive unit.

After the electronic part holder has picked up an electronic part, the frame is moved to a position where the electronic part is to be mounted. Then, the flat reflecting mirror is moved to below the electronic part and the camera takes a photograph of the top or bottom surface of the electronic part illuminated by the light source. When the image has been captured, the flat reflecting mirror is retracted to a position where it will not interfere with subsequent operations. By then determining the posture and position of the electronic part with reference to the central axis of the electronic part holder and allowing for the relative error with reference to the central point of the electronic part, the electronic part is positioned on a circuit board.

As such, the apparatus according to this invention permits determining the posture and position of the electronic part picked up through an image-based measurement that is performed without departing from the course of travel from the point of pickup to the point of mounting on the circuit board. This brings about an improvement in efficiency over the conventional process that necessitates moving the electronic part to a specific out-of-the-way point allocated for photographing. Furthermore, the apparatus according to this invention permits determining the posture and position of the electronic part to be mounted at high speed through an image-based measurement by switching the light source according to the kind of electronic part to be mounted, irrespective of the shape thereof.

In addition, the apparatus according to this invention sends the image of an electronic part into the camera using only one piece of flat reflecting mirror. This feature reduces the loss of the amount of light due to multiple reflection that occurs when prism or other light-guiding means is used and simplifies measurement and maintenance procedures.

Thus, an object of this invention is to provide a surface-mounted electronic parts positioning apparatus with a capability to directly position electronic parts to desired points on a printed circuit board after they have been picked up irrespective of the structure of electronic parts, lead wires and terminals.

Another object of this invention is to provide a surface-mounted electronic parts positioning apparatus that maintains high levels of accuracy for a long period of time without requiring complex optical systems.

Yet another object of this invention is to provide a surface-mounted electronic parts positioning apparatus with a capability to permit easy selection of optimum method for determining the relative position of an electronic part with reference to the vacuum suction pickup tube through image-based measurement.

### Brief Description of the Drawings

Fig. 1 is a front view of a surface-mounting device equipped with electronic part positioning apparatus according to this invention.

Fig. 2 is a front view of an electronic part positioning apparatus according to this invention.

Fig. 3 is a perspective view showing the structure of a portion of the same electronic part positioning apparatus in the vicinity of the vacuum suction pickup tube.

Figs. 4(a) is a cross-sectional view of a first light source in the same electronic part positioning apparatus.

Figs. 4(b) is a top view of a first light source in the same electronic part positioning apparatus.

Figs. 5(a) is a cross-sectional view of a second light source in the same electronic part positioning apparatus.

Figs. 5(b) is a top view of a second light source in the same electronic part positioning apparatus.

Figs. 6(I) is schematic view illustrating the operation of the same electronic part positioning apparatus.

Fig. 6(II) is schematic view illustrating the operation of the same electronic part positioning apparatus.

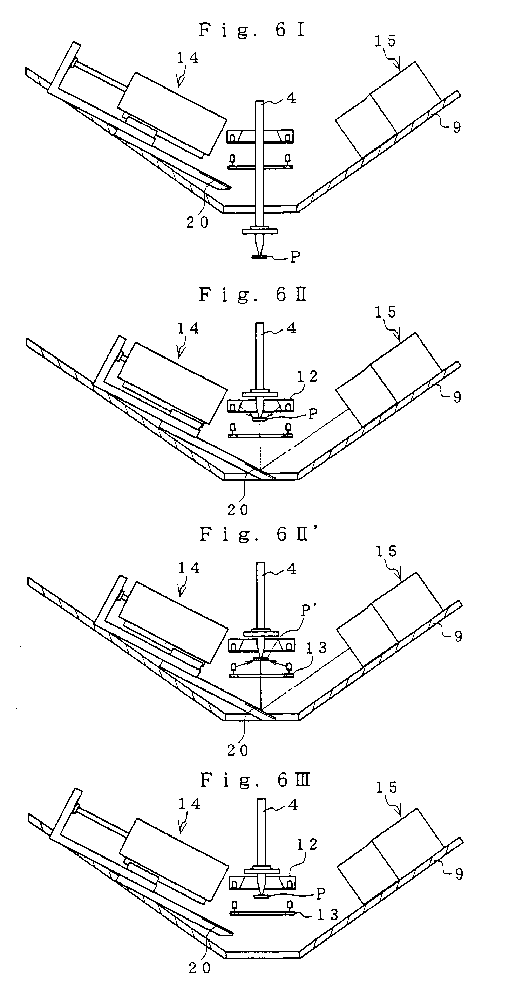

Fig. 6(II') is schematic view illustrating the operation of the same electronic part positioning apparatus.

Figs.6(III) is schematic view illustrating the operation of the same electronic part positioning apparatus.

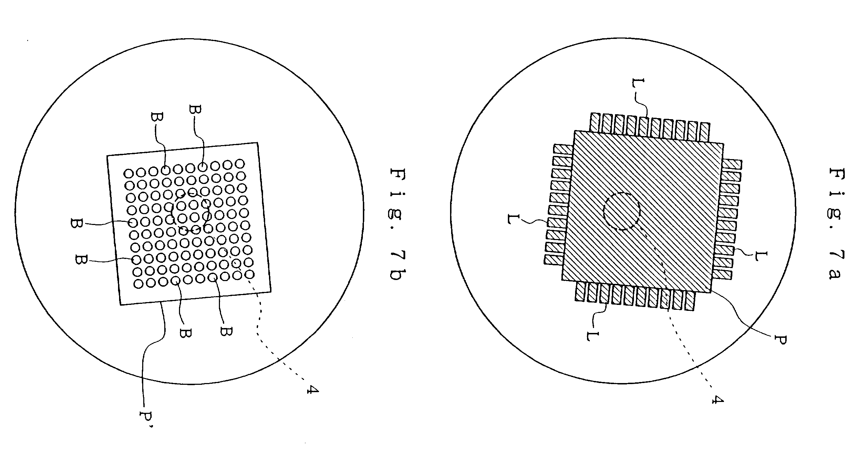

Figs. 7(a) shows images of electronic parts illuminated by the first and second light sources and picked up by a camera.

Figs. 7(b) shows images of electronic parts illuminated by the first and second light sources and picked up by a camera.

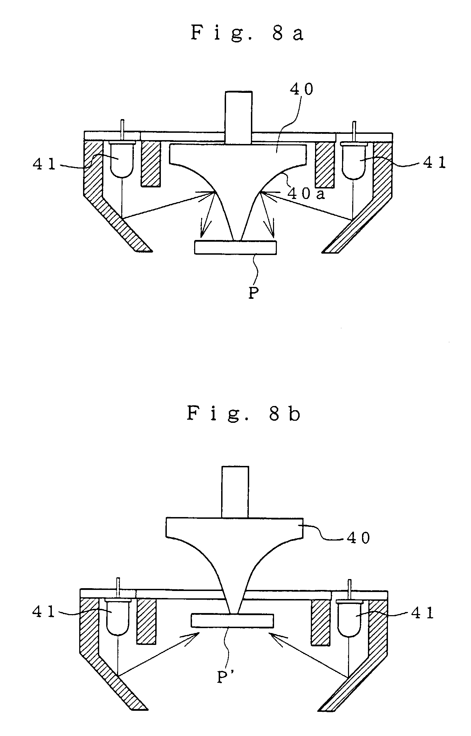

Figs. 8(a) shows how the image-based measurement of an electronic part is performed on other embodiments of this invention.

Figs. 8(b) shows how the image-based measurement of an electronic part is performed on other embodiments of this invention.

### Preferred Embodiments of the Invention

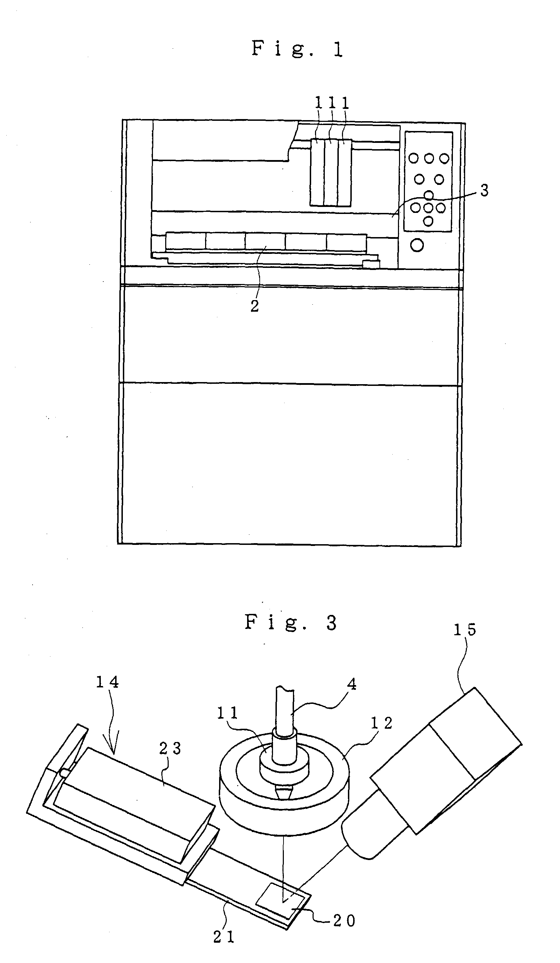

Fig. 1 shows an electronic part positioning apparatus equipped with electronic part positioning apparatus according to this invention. Multiple, such as three in this embodiment, electronic part positioning apparatus 1 according to this invention are mounted on a carrier traveling in the x and y directions over a circuit board table 3. An electronic part positioning apparatus picks up an electronic part from an electronic part storage area 2 and moves over the circuit board table 3 to a point where the electronic part is to be mounted while calculating the posture and position of the electronic part picked up.

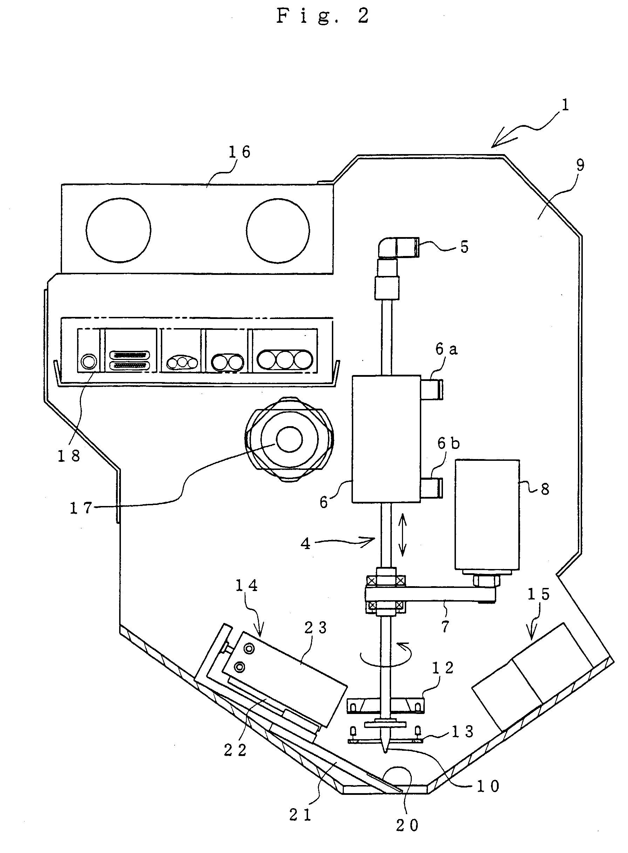

Fig. 2 shows an embodiment of the surface-mounted electronic parts positioning apparatus described above. A vacuum suction pickup tube 4 has a connection port 5 at the upper end thereof that is connected to a vacuum source. The vacuum suction pickup tube 4 is also moved up and down by a first drive unit 6 to which pneumatic pressure is supplied through air supply ports 6a and 6b and rotatably supported on a frame 9 by means of a second drive unit 8 comprising a motor through a belt 7.

A mirror 11 to reflect downward light from a first light source 12 described later is fixed to a point above an electronic part. A first and a second light sources 12 and 13 are disposed in such a way as to surround the vacuum suction pickup tube 4. A reflector 14 described later is disposed on one side of the vacuum suction pickup tube 4 and a camera 15 on the other side thereof.

The frame 9 for assembling the devices and units mentioned above has bearings 16 and 17 to engage with the shaft of the carrier, cables to supply signals and electricity to the camera 15, light sources 12 and 13, second drive unit 8, etc., and windows 18 through which tubes to supply a negative pressure to the vacuum suction pickup tube 4 and air to the first drive unit 6.

The reflector 14 comprises a flat reflecting mirror 20 that is set at such an angle that the image of the pickup end 10 of the vacuum suction pickup tube 4 enters the camera 15 and fixed on an arm 21. A guide member 22 moves the arm 21 parallel to the reflecting surface of the mirror 20, whereas an actuator, such as an air cylinder, moves the arm 21 back and forth between a point below the pickup end 10 of the vacuum suction pickup tube 4 and a point where the arm 21 offers no obstacle to the vertical motion of the vacuum suction pickup tube 4. The guide member 22 and arm 21 move along a surface that is parallel to the reflecting surface of the mirror 20.

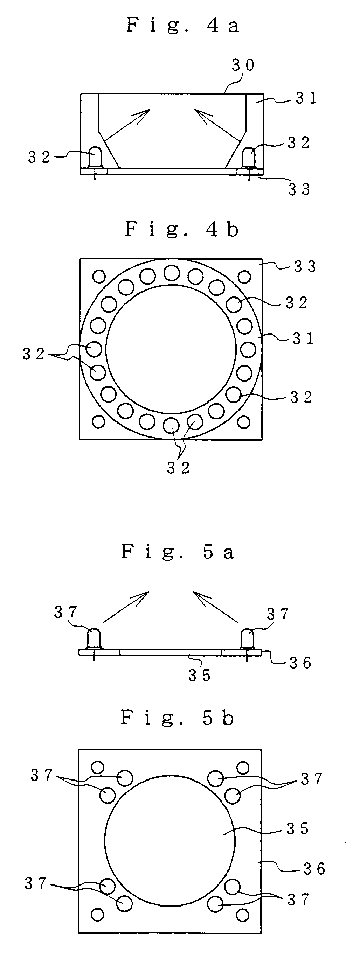

The first light source 11 comprises an annular member 31 of acrylic resin or other transparent material having a central window 30 through which the pickup end 10 of the vacuum suction pickup tube 4 can move, with multiple holes provided along the circumference of the annular member 31 and small light-emitting devices 32, such as light-emitting diodes, mounted on a base plate 33, as shown in Fig. 4.

The second light source 11 comprises multiple small light-emitting devices 37, such as light-emitting diodes, mounted on a base plate 36 that has a central window 35 through which the pickup end 10 of the vacuum suction pickup tube 4 can move, as shown in Fig. 5.

### [Positioning of Electronic Part Having Lead Wires around the Periphery of the Package]

After turning on the first light source 12 and moving the positioning device to an area where an electronic part is stored by actuating the carrier, the first drive unit 6 is actuated to lower the vacuum suction pickup tube 4 to pick up the electronic part (Fig. 6(I)). After the electronic part has been picked up, the vacuum suction pickup tube 4 is raised to a predetermined point below the first light source 12, the actuator 23 is actuated to move forward the flat reflecting mirror 20 to below the vacuum suction pickup tube 4 while moving the frame 9 to a point where the electronic part is to be mounted by means of the carrier (Fig. 6(II)).

Then, the silhouette of the electronic part P illuminated from behind is reflected by the mirror 20 and enters the camera 20, as shown in Fig. 7(a). After the image of the electronic part has been taken, the actuator 23 is actuated to move the mirror 20 back to the original position where it offers no obstacle to the subsequent mounting of the electronic part by the vacuum suction pickup tube 4 (Fig. 6(III)).

Moved by sliding the guide member 22 that is disposed so that the guide surface is parallel to the mirror 20, with the angle of reflection thus always set at the originally set one, the mirror 20 can process the image of the electronic part P with high accuracy and reliability.

Being a silhouette, the image detected by the camera 15 can be processed as a binary data. Because binary data is small, the posture and position of the electronic part with reference to the center axis of the vacuum suction pickup tube 4 can be determined quickly. Depending on the result thus obtained, the position of the electronic part is corrected as desired by rotating the vacuum suction pickup tube 4. Then, the electronic part is positioned on the circuit board by taking into account the relative error between the center axis of the vacuum suction pickup tube and the central point of the electronic part.

### [Positioning of Electronic Part Having a Connector on the Back Side of the Package]

After turning on the second light source 13 and moving the positioning device to an area where an electronic part is stored by actuating the carrier, the first drive unit 6 is actuated to lower the vacuum suction pickup tube 4 to pick up the electronic part (Fig. 6(I)). After the electronic part has been picked up, the vacuum suction pickup tube 4 is raised, by means of the first drive unit 6, to a predetermined point where the electronic part P' picked up by the pickup end 10 is positioned between a point above the second light source 13 and below the first light source 12, the actuator 23 is actuated to move forward the flat reflecting mirror 20 to below the vacuum suction pickup tube 4 while moving the frame 9 to a point where the electronic part is to be mounted by means of the carrier (Fig. 6(II')) .

Then, the image of the connector comprising pins and solder balls B on the back side of the electronic part P' is reflected y the mirror 20 and enters the camera 15, as shown in Fig. 7(b)) . After the image of the electronic part has been taken, the actuator 23 is actuated to move the mirror 20 back to the original position where it offers no obstacle to the subsequent mounting of the electronic part by the vacuum suction pickup tube 4 (Fig. 6(III)).

Based on the image signal from the camera 15, the posture and position of the electronic part with reference to the center axis of the vacuum suction pickup tube 4. Depending on the result thus obtained, the position of the electronic part is corrected as desired by rotating the vacuum suction pickup tube 4 by means of the second drive unit 8. Then, the electronic part is positioned on the circuit board by taking into account the relative error between the center axis of the vacuum suction pickup tube and the central point of the electronic part.

In the embodiment described above, either of the silhouette or image of the electronic part is selected by switching the two light sources. Instead, an electronic part pickup 40 shaped like a top may be provided. The electronic part P that permits image processing based on its silhouette is illuminated by the light from a light source 41 that is reflected by the surface 40a of the pickup 40. With the electronic part P' that requires the use of its image, rather than its silhouette, the pickup 40 is raised so that the light source 41 directly illuminates the electronic part P', as shown in Fig. 8(b).

## Claims

1. A surface-mounted electronic parts positioning apparatus comprising:
a vertically movable and rotatable electronic part holder holding an electronic part with the back side thereof directed downside;
a light source selectively illuminating either of the top and bottom surfaces of said electronic part;
a flat reflecting mirror adapted to reciprocate below the axis of said electronic part holder;
a camera disposed in a plane containing said flat reflecting mirror and electronic part holder and in a position where the image of the electronic part holder enters; and
a frame driven by a drive unit and carrying all of the foregoing components.

2. A surface-mounted electronic parts positioning apparatus according to claim 1, in which the flat reflecting mirror is fastened to an arm guided by a guide member extending parallel to the reflecting surface of said flat reflecting mirror.

3. A surface-mounted electronic parts positioning apparatus according to claim 1, in which a reflecting member is provided in the vicinity of the electronic part pickup end of said electronic part holder.

4. A surface-mounted electronic parts positioning apparatus according to claim 1, in which said electronic part holder comprises a vacuum suction pickup tube operating on a negative pressure supplied thereto.

5. A surface-mounted electronic parts positioning apparatus according to claim 1, in which said light source comprises a first and a second light sources adapted to illuminated at different levels, having a window centered around the axis of said electronic part holder, and having multiple light-emitting elements disposed along the periphery of said window.

6. A surface-mounted electronic parts positioning apparatus according to claim 1, in which said light source is adapted to illuminate an area diagonally above the center axis of said electronic part holder and said electronic part holder adjusts the level of said electronic part, whereby either the top or bottom side of said electronic part is selectively illuminated.
